# Europäisches Patentamt

## European Patent Office

## Office européen des brevets

(19)

(11) Veröffentlichungsnummer: **0 152 588**
**B1**

(12)

# EUROPÄISCHE PATENTSCHRIFT

(45) Veröffentlichungstag der Patentschrift:
**07.10.87**

(51) Int. Cl.⁴: **G 01 N 24/06, H 01 F 7/20**

(21) Anmeldenummer: **84115316.6**

(22) Anmeldetag: **12.12.84**

(54) **Gradientenspulen-System für eine Anlage zur kernspintomographie.**

(30) Priorität: **20.02.84 DE 3406052**

(43) Veröffentlichungstag der Anmeldung:
**28.08.85 Patentblatt 85/35**

(45) Bekanntmachung des Hinweises auf die Patenterteilung:
**07.10.87 Patentblatt 87/41**

(84) Benannte Vertragsstaaten:
**DE FR GB NL**

(56) Entgegenhaltungen:
**EP - A - 0 011 335**
**EP - A - 0 056 691**
**EP - A - 0 073 402**
**EP - A - 0 086 560**
**US - A - 4 411 270**

(73) Patentinhaber: **Siemens Aktiengesellschaft Berlin und München, Wittelsbacherplatz 2, D-8000 München 2 (DE)**

(72) Erfinder: **Maurer, Arnolf, Dr., Wiesenweg 54, D-8526 Bubenreuth (DE)**
Erfinder: **Siebold, Horst, Dr., Reuthlehenstrasse 63, D-8520 Erlangen (DE)**

ACTORUM AG

## Beschreibung

Die Erfindung bezieht sich auf ein Gradientenspulen-System für eine Anlage zur Kernspintomographie, das einen hohlzylindrischen Trägerkörper umschliesst, dessen Zylinderachse in z-Richtung eines rechtwinkligen x-y-z-Koordinatensystems mit dem Koordinatenursprung im Zentrum eines Abbildungsbereiches verläuft, in welche Richtung auch das magnetische Feld $B_z$ eines mehrere Feldspulen umfassenden Grundfeldmagneten orientiert ist, welches Gradientenspulen-System zur Erzeugung eines in dem Abbildungsbereich weitgehend konstanten Feldgradienten $G_z = \dfrac{\delta B_z}{\delta z}$ mindestens zwei ringförmige, zumindest annähernd symmetrisch zu der durch das Zentrum des Abbildungsbereiches verlaufenden x-y-Ebene angeordnete Einzelspulen und ferner mindestens je einen Satz von bezüglich dieser Symmetrieebene zumindest annähernd symmetrisch angeordneten Paaren sattelförmiger Einzelspulen enthält, die zur Erzeugung von in dem Abbildungsbereich weitgehend konstanten Feldgradienten $G_x = \dfrac{\delta B_z}{\delta x}$ in x-Richtung bzw. entsprechenden Feldgradienten $G_y = \dfrac{\delta B_z}{\delta y}$ in y-Richtung vorgesehen sind. Ein solches Gradientenspulen-System ist z.B. aus der veröffentlichten europäischen Patentanmeldung EP 56 691 A1 zu entnehmen.

Auf dem Gebiet der medizinischen Diagnostik sind bildgebende Verfahren entwickelt worden, bei denen durch rechnerische oder messtechnische Analyse integraler Resonanzsignale von Kernen wie z.B. Protonen aus der räumlichen Spindichte- und/oder Relaxationszeitverteilung eines zu untersuchenden, insbesondere menschlichen Körpers ein Bild ähnlich einem Röntgentomogramm konstruiert wird. Das entsprechende Verfahren wird als Kernspitomographie oder auch als Zeugmatographie bezeichnet («Nature», Vol. 242, 1973, Seiten 190 und 191).

Für Anlagen zur Kernspintomographie (Nuclear Magnetic-Resonance Tomography-Anlagen) wird ein starkes stationäres Grundfeld beispielsweise der Grössenordnung $B_0 = 1,5$ T angestrebt, von dessen Stärke die Grösse des Resonanzsignals abhängt und an das hinsichtlich seiner Homogenität hohe Anforderungen gestellt werden. So soll z.B. ein entsprechender im allgemeinen aus mehreren Teilspulen bestehender Grundfeldmagnet in einem kugelförmigen Volumen von ca. 50 cm Durchmesser nur noch eine Feldabweichung von weniger als 50 ppm aufweisen.

Dieses magnetische Grundfeld sei z.B. in z-Richtung eines rechtwinkligen x-y-z-Koordinatensystems orientiert, wobei die z-Achse die Untersuchungsachse ist, längs derer der zu untersuchende Körper in das Magnetfeld eingebracht wird. Der Koordinatenursprung soll dabei in das Zentrum des Abbildungs- bzw. Untersuchungsbereiches gelegt sein.

Ferner ist eine Hochfrequenz-Spulenanordnung für die entsprechende Präzessionsfrequenz der zu betrachtenden Kernspins vorzusehen, um diese Spins anzuregen und gegebenenfalls auch die Induktionssignale empfangen zu können.

Schliesslich wird noch ein System von unabhängig voneinander arbeitenden Gradientenspulen benötigt, die einen vorzugsweise orthogonalen Satz von Zusatzfeldern mittels Feldgradienten $G_z = \dfrac{\delta B_z}{\delta z}$, $G_x = \dfrac{\delta B_z}{\delta x}$ und $G_y = \dfrac{\delta B_z}{\delta y}$ erzeugen. Diese Zusatzfelder sind klein gegen das in z-Richtung orientierte Grundfeld $B_z$. Erst die in einer vorbestimmten Reihenfolge eingeschalteten Gradientenfelder erlauben eine Unterscheidung im Ort durch den Verlauf der Präzessionsfrequenz der Kerne über dem Ort (vgl. z.B. «Journal of Magnetic Resonance», Vol. 18, 1975, Seiten 69 bis 83 oder Vol. 29, 1978, Seiten 355 bis 373).

Allgemein lassen sich die genannten Feldgradienten $G_x$, $G_y$ und $G_z$ durch magnetische Quadrupole erzeugen. Für Anlagen zur Kernspintomographie muss dabei berücksichtigt werden, dass diese Spulen im Inneren des Grundfeldmagneten angeordnet werden müssen, wobei für die Lagerung des zu untersuchenden Körpers genügend Raum offen bleiben muss.

Die entsprechenden Gradientenspulen der aus der genannten EP-A1 bekannten Kernspintomographie-Anlage sind mit einem hohlzylindrischen Trägerkörper starr verbunden, welcher in den Grundfeldmagneten eingeschoben werden kann, wobei die Trägerachse mit der Magnetachse zusammenfällt und in z-Richtung eines rechtwinkligen x-y-z-Koordinatensystems weist. Der z-Gradient $G_z$ wird durch zwei Ringspulen erzeugt, die symmetrisch zu einer senkrecht bezüglich der Zylinderachse ausgerichteten, durch das Zentrum des Abbildungsbereiches verlaufenden x-y-Ebene angeordnet sind. Zur Erzeugung des x-Gradienten $G_x$ sind zwei Paare von sattelförmigen Spulen vorgesehen, wobei die Spulen jedes Paares in diametraler Lage auf den Aussenmantel des hohlzylindrischen Trägerkörpers aufgebracht sind. Für den y-Gradienten $G_y$ ist ein entsprechendes System von vier Sattelspulen vorgesehen, die gegenüber den x-Gradientenspulen auf dem Trägerkörper um 90° in Umfangsrichtung versetzt angeordnet sind. Die beiden Paare von Einzelspulen jedes Spulensatzes liegen dabei symmetrisch zu beiden Seiten der genannten x-y-Ebene.

Neben einer direkten Befestigung der einzelnen Gradientenspulen auf dem hohlzylindrischen Trägerkörper kann gegebenenfalls auch ein besonderes Montagerohr verwendet werden, auf dem die einzelnen Spulen aufgebracht sind. Das Montagerohr selbst wird dann an dem wesentlich längeren, innenliegenden hohlzylindrischen Trägerkörper abgestützt.

Form, Aufteilung und Anordnung der einzelnen $G_x$- und $G_y$-Sattelspulen und der $G_z$-Ringspule sind vorgegeben. Bei deren Betrieb in dem starken Grundfeld treten sogenannte Lorentzkräfte auf, die als Streckenlasten an den Spulen angreifen. Diese Lorentzkräfte sind aufgrund typischer Schaltfolgen der einzelnen Gradientenfelder in den Spulen veränderlich, so dass diese Spulen selbst zu erzwungenen Schwingungen angeregt werden. Durch Körperschall und Luftschall wird dann die eingekoppelte Energie von dem Spulensystem, gegebenenfalls über das besondere Montagerohr, auf das hohlzylindrische Trägerrohr übertragen, das quasi als Lautsprechermembran wirkt und somit den den zu untersuchenden Körper aufnehmenden Raum mit Schallwellen durchsetzt, deren Frequenzen hauptsächlich im Bereich zwischen 200 Hz und 1000 Hz liegen. So konnten beispielsweise im Zentrum des Nutzvolumens Schallpegel bis 95 dB(A) gemessen werden, die für einen zu untersuchenden Patienten unerträglich hoch ligen. Zur Begrenzung der abgestrahlten Leistung kann man zwar die Gradientenspulen mit geringerem Nennstrom betreiben, dies führt jedoch zu einer entsprechenden Verminderung der Bildqualität der Kernspintomographie-Anlage.

Aufgabe der vorliegenden Erfindung ist es deshalb, das eingangs genannte Gradientenspulen-System so auszugestalten, dass eine Reduzierung des von ihm in dem hohlzylindrischen Trägerkörper hervorgerufenen Schallpegels erreicht wird, ohne dass damit eine Verminderung der Bildqualität verbunden ist.

Diese Aufgabe wird erfindungsgemäss mit den im Kennzeichen des Hauptanspruchs angegebenen Massnahmen gelöst.

Gemäss der Erfindung wird also auf ein besonderes Montagerohr für die Gradientenspulen und auch auf ein direktes Aufbringen dieser Spulen auf dem rohrförmigen Trägerkörper ganz verzichtet. Statt dessen wird eine möglichst steife Verbindung aller Sattelspulen des x- und y-Gradientensystems zu einem selbsttragenden Spulenkorb vorgesehen. Die Ringspulen des z-Gradientensystems können zur zusätzlichen Versteifung dienen. Dabei ist der gesamte Spulenkorb so aufgebaut, dass innere Drehmomente, die infolge der Wechselkräfte während der Schaltfolgen von x- bzw. y-Gradienten an den einzelnen Spulen angreifen, zu jedem Zeitpunkt zumindest weitgehend kompensiert werden. Die mit dieser Ausgestaltung des Gradientenspulen-Systems verbundenen Vorteile sind insbesondere darin zu sehen, dass sich der Spulenkorb dann über verhältnismässig elastische Abstützungselemente an dem hohlzylindrischen Trägerkörper anbringen lässt und sich damit die Übertragung der Schwingungen des Spulenkorbes auf den Trägerkörper entsprechend dämpfen lässt. Die in den Abbildungsbereich abgestrahlte Schalleistung ist somit dementsprechend reduziert.

Vorteilhafte Ausgestaltungen des Gradientenspulen-Systems nach der Erfindung gehen aus den abhängigen Ansprüchen hervor.

Zur weiteren Erläuterung der Erfindung und deren in den abhängigen Ansprüchen gekennzeichneten Weiterbildungen wird auf die Zeichnung Bezug genommen, in deren Fig. 1 und 2 eine Aufsicht auf bzw. ein Teilquerschnitt durch ein Gradientenspulen-System nach der Erfindung schematisch veranschaulicht sind. Die Fig. 3 bis 6 zeigen zwei besondere Ausgestaltungsmöglichkeiten von Trägerelementen und Fig. 7 eine besondere Ausführungsform von sattelförmigen Einzelspulen für dieses Gradientenspulen-System.

Bei der Anlage zur Kernspintomographie, für welche das Gradientenspulen-System nach der Erfindung vorgesehen sein soll, wird von bekannten Magnetspulenanordnungen ausgegangen. Eine entsprechende Magnetspulenanordnung ist z.B. in der eingangs genannten EP-A1 angedeutet. Diese Magnetspulenanordnung hat mindestens ein bezüglich der z-Achse eines rechtwinkligen x-y-z-Koordinatensystems konzentrisch angeordnetes, insbesondere supraleitendes Feldspulensystem zur Erzeugung eines homogenen magnetischen Grundfeldes in z-Richtung. Ferner sind Gradientenspulen zur Erzeugung hinreichend konstanter magnetischer Feldgradienten in einem Abbildungsbereich vorgesehen, in dessen Zentrum sich der Ursprung des Koordinatensystems finden soll. Die Magnetspulenanordnung erlaubt einen axialen Zugang zum homogenen Feldbereich in ihrem Zentrum, d.h. der zu untersuchende, insbesondere menschliche Körper wird längs der z-Achse in das Magnetfeld eingebracht. Die Anregung der Kernspins erfolgt mittels eines senkrecht zur z-Achse gerichteten Hochfrequenzfeldes von Spulen, die auch als Empfängerspulen zur Aufnahme der Kernspinresonanzsignale dienen können.

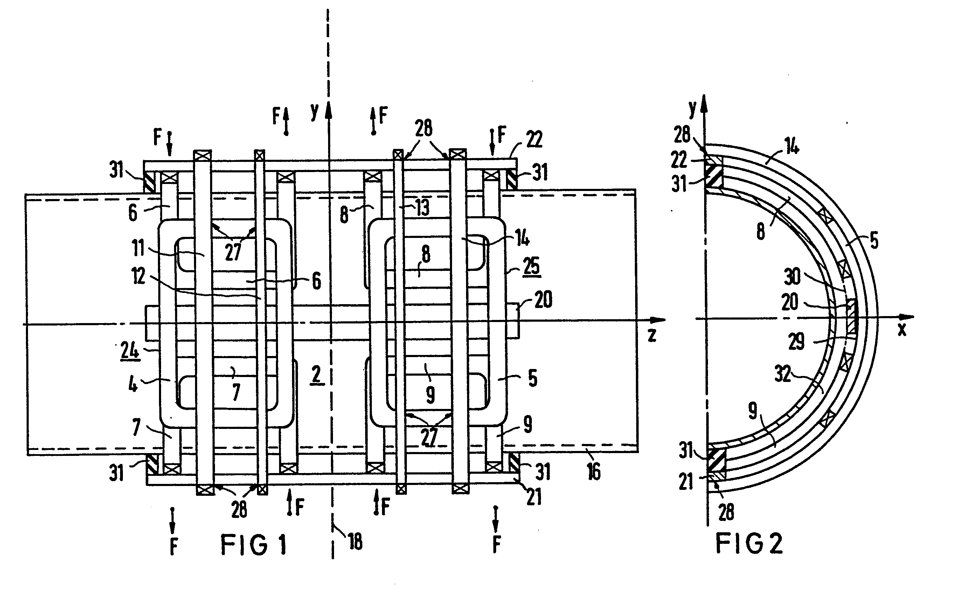

Für einen solche Anlage zur Kernspintomographie kann vorteilhaft das Gradientenspulen-System nach der Erfindung vorgesehen sein. Die Anordnung der einzelnen Spulen dieses Systems geht aus den Fig. 1 und 2 näher hervor, wobei in den Figuren gleiche Teile mit den gleichen Bezugzeichen versehen sind. Das Spulensystem, mit dem in einem Abbildungsbereich hinreichend lineare Gradientenfelder in x-, y- und z-Richtung erzeugt werden sollen, ist gemäss der Erfindung als selbsttragender hohlzylindrischer Spulenkorb gestaltet, der in den Figuren allgemein mit 2 bezeichnet ist. Dieser Spulenkorb enthält zwei Paare von je zwei sattelförmigen Einzelspulen sowie einen Satz von vorzugsweise vier ringförmigen Einzelspulen (vgl. DE-OS 3 133 933). Gemäss der Darstellung nach den Figuren sind nur sattelförmige Spulen 4 bis 9 und ringförmige Spulen 11 bis 14 zumindest teilweise ersichtlich. Diese Einzelspulen umschliessen einen hohlzylindrischen Trägerkörper 16, dessen Zylinderachse in z-Richtung eines rechtwinkligen x-y-z-Koordinatensystems weisen soll. Die z-Achse ist zugleich die Untersuchungsachse, längs derer der zu untersuchende Körper in den Untersuchungs- bzw. Abbildungsbereich eingebracht werden kann. In diesem Bereich soll ein magnetisches Feld $B_z$ eines nicht dargestellten Grundfeldmagneten zumindest weitgehend homogen und in z-Richtung orientiert sein. Der Koordinatenursprung des x-y-z-Koordinatensystems ist in das Zentrum dieses Abbildungsbereiches gelegt.

Die sattelförmigen Einzelspulen 6 und 7 sowie 8 und 9 bilden je ein Spulenpaar, das beispielsweise zur Erzeugung des $C_y$-Gradientenfeldes dient, während dann die Spulen 4 und 5 jeweils die eine Hälfte eines Spulenpaares zur Erzeugung des $G_x$-Gradientenfeldes darstellten. Die beiden $G_x$-Spulenpaare sowie die entsprechenden $G_y$-Spulenpaare sind bezüglich einer durch das Zentrum des Abbildungsbereiches verlaufenden x-y-Ebene symmetrisch angeordnet. Diese Symmetrieebene ist durch eine gestrichelte Linie 18 angedeutet. In entsprechender Weise liegen auch die ringförmigen $G_z$-Einzelspulen 11 und 12 symmetrisch zu den Ringspulen 13 und 14 bezüglich dieser Ebene 18.

Die acht sattelförmigen Einzelspulen sowie die beispielsweise vier ringförmigen Einzelspulen des Gradientenspulen-Systems nach der Erfindung bilden zusammen mit mehreren, vorzugsweise mit vier in z-Richtung verlaufenden Trägerelementen den in sich steifen, selbsttragenden Spulenkorb 2. Aus Fig. 1 sind nur sechs der acht sattelförmigen Spulenwicklungen 4 bis 9, die vier ringförmigen Einzelspulen 11 bis 14 sowie nur drei Trägerelemente 20 bis 21 der vier angenommenen Trägerelemente ersichtlich. Der Spulenkorb 2 ist folgendermassen aufgebaut: Auf jeder Seite bezüglich der x-y-Symmetrieebene 18 bilden je vier Sattelspulen und zwei Ringspulen einen rohrförmigen Teilkorb 24 bzw. 25. Dementsprechend sind dem Teilkorb 24 die aus Fig. 1 ersichtlichen Einzelspulen 4, 6, 7, 11 und 12 und dem Teilkorb 25 die entsprechenden Einzelspulen 5, 8, 9, 13 und 14 zugeordnet. In jedem Teilkorb liegen sich je zwei Sattelspulen des x- bzw. y-Gradientenspulensystems diametral gegenüber. Die einzelnen, vorgeformten Sattelspulen sind vorteilhaft zumindest weitgehend baugleich und können sich insbesondere an ihren längsseitigen Rändern überlappen. So kann beispielsweise gemäss der dargestellten Ausführungsform die Überlappungszone einen Winkel von etwa 37° einnehmen. Fordert man hohe Formgenauigkeit, so lassen sich die vier Sattelspulen eines Teilkorbes zu einer möglichst starren Struktur verkleben. Bei variierendem Spalt, hervorgerufen durch Fertigungstoleranzen, zwischen den übereinanderliegenden Spulen bietet sich ein Vergiessen mit einem zähplastischen Material z.B. einem Kunstharz an. Zur weiteren Versteifung der Teilkörbe sind die jeweiligen Ringspulen 11 und 12 bzw. 13 und 14 an den Kreuzungsbereichen 27 mit den von ihnen umschlossenen Sattelspulen beispielsweise durch Klemmen oder durch Kleben starr verbunden.

Die beiden Teilkörbe 24 und 25 des erfindungsgemässen Spulensystems sind mittels der Trägerelemente 20 bis 22 zu dem gesamten Spulenkorb 2 starr miteinander verbunden. Hierzu erstrecken sich zwei Trägerelemente (20) über die vier x-Gradientenspulen (4 und 5) sowie die beiden weiteren Längsträgerelemente 21 und 22 über die vier y-Gradientenspulen 6 bis 9. Die Trägerelemente können beispielsweise eine rechteckige Querschnittsform aufweisen. Insbesondere lässt sich aber auch ein T-förmiger Querschnitt vorsehen, wobei dann in den Trägerelementen im Bereich der Kreuzungspunkte mit den jeweiligen Gradientenspulen entsprechende Nuten vorgesehen sind, in welche die Spulen eingepasst sind. Wie insbesondere aus der stirnseitigen Teilansicht der Fig. 2 hervorgeht, liegen die die Einzelspulen 8 und 9 mit den Einzelspulen 6 und 7 verbindenden Trägerelemente 21 und 22 gemeinsam mit den Einzelspulen 4 und 5 aussen auf einer Zylinderfläche 29. Diese äussere Zylinderfläche umschliesst dabei die Einzelspulen 6 bis 9, die ihrerseits auf einer konzentrischen Zylinderfläche 30 angeordnet sind. Auf dieser inneren Zylinderfläche 30 befinden sich auch die Trägerelemente 20 welche die Einzelspulen 4 und 5 verbinden. Auf diese Weise lässt sich erreichen, dass trotz unterschiedlicher radialer Positionen der x- und y-Gradientenspulen kein zusätzlicher radialer Raum für die Trägerelemente erforderlich wird. Die Ringspulen 11 bis 14 des z-Gradientensystems können dann in allen Kreuzungsbereichen 27 mit den äusseren Einzelspulen 5 und in den Kreuzungsbereichen 28 mit den äusseren Trägerelementen 21 und 22 starr verbunden, beispielsweise mechanisch verklammert oder verklebt werden. Will man eine noch höhere Steifigkeit des Gesamtkorbes 2 erreichen, so können die Ringspulen 11 bis 14 zusätzlich auch mit den Trägerelementen 20 verbunden werden, indem geeignet geformte Zwischenstücke den radialen Abstand zwischen den Spulen und Elementen in den jeweiligen Überkreuzungsbereichen ausfüllen und diese Teile dort dann kraftschlüssig miteinander verklebt werden.

Die in z-Richtung verlaufenden Trägerelemente 20 bis 22 werden vorteilhaft in der Mitte der in Umfangsrichtung sich erstreckenden Bogenteile der sattelförmigen Spulen mit diesen verbunden, da sich dort die Schwerpunkte der Lorentzkräfte der einzelnen Spulen befinden. Das bedeutet, dass nur Kräfte, aber keine Momente in die Trägerelemente eingekoppelt werden. In Fig. 1 sind durch gepfeilte Linien die Kräfte F veranschaulicht, welche bei Betrieb des y-Gradientenspulensystems wirken. F ist dabei die über das Bogenstück der jeweiligen Sattelspule vektoriell integrierte Lorentzkraft. Gegebenenfalls kann auch eine grössere Anzahl von Trägerelementen und dementsprechend eine vom Ausführungsbeispiel abweichende Anordnung dieser Elemente vorgesehen werden. Als Materialien für die Trägerelemente sind isolierende, nichtmagnetische Werkstoffe geeignet, die eine ausreichende Steifigkeit des Spulenkorbes 2 gewährleisten. Besonders geeignet sind Schichtholz oder glasfaserverstärkte Kunststoffe, die niedriges spezifisches Gewicht haben. Wegen der grösseren Eigendämpfung durch innere Reibung ist ein glasfaserverstärktes Kunststoffmaterial besonders vorteilhaft.

Die Lagerung des Spulenkorbes 2 erfolgt über besondere isolierende, verhältnismässig elastische Abstützungselemente 31 wie z.B. Gummiformteile, die an mehreren vorbestimmten axialen Positionen zwischen den Trägerelementen 20 bis 22 und dem hohlzylindrischen Trägerkörper 16 angebracht sind. Die axialen Positionen dieser Abstützungselemente sind dabei so festgelegt, dass sie für den Spulenkorb 2 und den Trägerkörper 16 in möglichst schwingungsarmen Zonen zu liegen kommen.

Da bei den erfindungsgemässen Ausgestaltungen des Gradientenspulen-Systems in Form eines Spulenkorbes 2 ein besonderes starres Montagerohr für die Spulen entfällt, bleibt im allgemeinen zwischen dem Spulenkorb und dem ihn tragenden hohlzylindrischen Trägerkörper 16 ein freier Spalt 32 von einer radialen Ausdehnung von einigen Zentimetern. In diesem Spalt können vorteilhaft luftschallabsorbierende Teile wie z.B. Matten aus porösem Material, z.B. aus Fasern oder offenzelligen Schäumen, untergebracht werden.

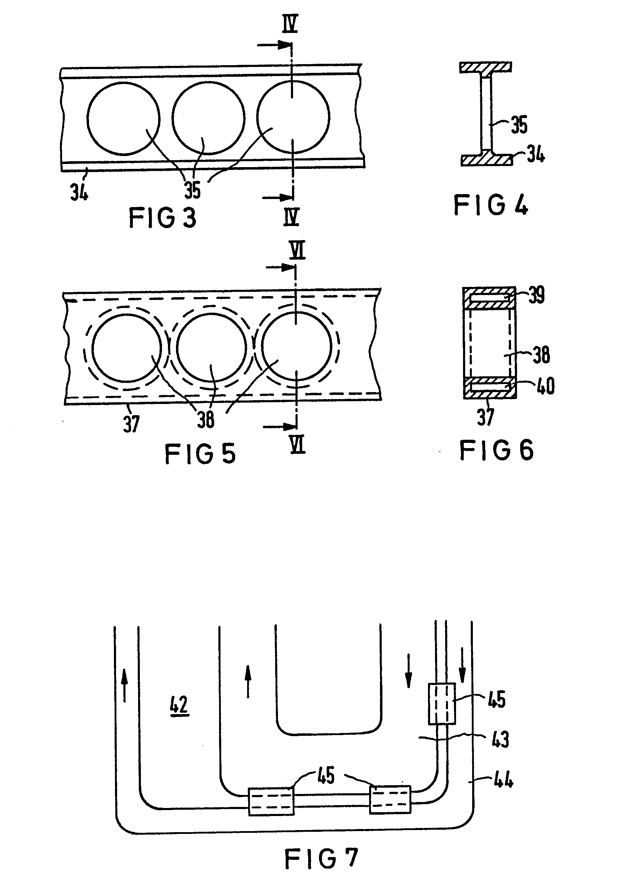

Die von den schwingenden Teilen des Spulenkorbes 2 senkrecht zu deren Oberflächen abgestrahlte Schalleistung kann weiter verringert werden, wenn verhältnismässig grosse Flächen in mehrere kleine Teilflächen aufgelöst werden. Aus den Fig. 3 bis 7 sind einige entsprechende Massnahmen zu entnehmen. So können beispielsweise gemäss den Fig. 3 bis 6 besonders gestaltete in z-Richtung verlaufende Trägerelemente verwendet werden. So ist das in den Fig. 3 und 4 als Aufsicht bzw. im Querschnitt gezeigte. Trägerelement 34, das insbesondere aus einem glasfaserverstärkten Kunststoff bestehen kann, mit in z-Richtung hintereinanderliegenden, beabstandeten kreisförmigen Ausnehmungen 35 versehen. Das Trägerelement 34 selbst hat dabei eine Doppel-T-Form.

Aus den Fig. 5 und 6 geht ein weiteres Ausführungsbeispiel für ein entsprechendes Trägerelement 37 in den Fig. 3 und 4 entsprechender Darstellung hervor. Dieses ebenfalls mit kreisförmigen Ausnehmungen 38 versehene Trägerelement hat jedoch im Gegensatz zu dem Trägerelement 34 nach den Fig. 3 und 4 eine rechteckige Querschnittsform. Dabei kann in den den Schmalseiten zuzuordnenden Randbereichen des Trägerelementes jeweils ein schmaler, sich in z-Richtung erstreckender Hohlraum 39 bzw. 40 ausgebildet sein.

Eine Auflösung der schwingenden Flächen in kleinere Teilflächen kann auch für die Sattelspulen vorgesehen werden. Ein entsprechendes Ausführungsbeispiel geht aus der Teilaufsicht der Fig. 7 hervor. Danach können zumindest einige der Sattelspulen 42 des erfindungsgemässen Gradientenspulen-Systems in Teilsättel 43 und 44 aufgetrennt werden (vgl. z.B. DE-OS 3 133 873). Diese Teilsättel 42 und 43 sind durch besondere elastische Formstücke 45, beispielsweise aus Gummi, auf Abstand gehalten.

**Patentansprüche**

1. Gradientenspulen-System für eine Anlage zur Kernspintomographie, das einen hohlzylindrischen Trägerkörper (16) umschliesst, dessen Zylinderachse in z-Richtung eines rechtwinkligen x-y-z-Koordinatensystems mit dem Koordinatenursprung im Zentrum eines Abbildungsbereiches verläuft, in welche Richtung auch das magnetische Feld $B_z$ eines mehrere Feldspulen umfassenden Grundfeldmagneten orientiert ist, welches Gradientenspulen-System zur Erzeugung eines in dem Abbildungsbereich weitgehend konstanten Feldgradienten $G_z = \dfrac{\delta B_z}{\delta z}$ mindestens zwei ringförmige, zumindest annähernd symmetrisch zu der durch das Zentrum des Abbildungsbereiches verlaufenden x-y-Ebene (18) angeordnete Einzelspulen und ferner mindestens je einen Satz von bezüglich dieser Symmetrieebene (18) zumindest annähernd symmetrisch angeordneten Paaren sattelförmige Einzelspulen enthält, die zur Erzeugung von in dem Abbildungsbereich weitgehend konstanten Feldgradienten $G_x = \dfrac{\delta B_z}{\delta x}$ in x-Richtung bzw. entsprechenden Feldgradienten $G_y = \dfrac{\delta B_z}{\delta y}$ in y-Richtung vorgesehen sind, dadurch gekennzeichnet,

a) dass die jeweils auf einer Seite bezüglich der x-y-Symmetrieebene (18) liegenden vorgefertigten sattelförmigen $G_x$- und $G_y$-Gradientenspulen (4, 6 und 7 bzw. 5, 8 und 9) untereinander zu einem selbsttragenden Teilkorb (42), (24 bzw. 25) starr verbunden sind,

b) dass die zu beiden Seiten der x-y-Symmetrieebene (18) ausgebildeten Teilkörper (24, 25) mittels mehrerer in z-Richtung verlaufender Trägerelemente (20 bis 22, 34, 37) aus unmagnetischem isolierendem Material einen gemeinsamen, selbsttragenden Spulenkorb (2) bilden, an dem die vorgefertigten ringförmigen $G_z$-Gradientenspulen (11 bis 14) befestigt sind, und

c) dass der Spulenkorb (2) über isolierende, elastische Abstützelemente (31) an dem hohlzylindrischen Trägerkörper (16) angebracht ist.

2. Gradientenspulen-System nach Anspruch 1, dadurch gekennzeichnet, dass die sattelförmigen $G_x$- und $G_y$-Gradientenspulen (4 bis 9) eine derartige Ausdehnung in Umfangsrichtung aufweisen, dass sie sich gegenseitig überlappen.

3. Gradientenspulen-System nach Anspruch 2, dadurch gekennzeichnet, dass die sattelförmigen Gradientenspulen (4, 5 bzw. 6 bis 9) auf verschiedenen Zylinderflächen (29, 30) angeordnet sind.

4. Gradientenspulen-System nach Anspruch 2 oder 3, dadurch gekennzeichnet, dass die sattelförmigen Gradientenspulen (4 bis 9) in ihren gegenseitigen Überlappungszonen miteinander mechanisch verklammert und/oder verklebt sind.

5. Gradientenspulen-System nach einem der Ansprüche 1 bis 4, dadurch gekennzeichnet, dass die in z-Richtung verlaufenden Trägerelemente (20 bis 22) jeweils an den in Umfangsrichtung verlaufenden Bogenteilen der sattelförmigen Gradientenspulen (4 bis 9) befestigt sind.

6. Gradientenspulen-System nach einem der Ansprüche 1 bis 5, dadurch gekennzeichnet, dass die ringförmigen $G_z$-Gradientenspulen (11 bis 14) an den radial aussenliegenden sattelförmigen Gradientenspulen (4, 5) und Trägerelementen (21, 22) befestigt sind.

7. Gradientenspulen-System nach einem der Ansprüche 1 bis 6, dadurch gekennzeichnet, dass die in z-Richtung verlaufenden Trägerelemente (20 bis 22) aus einem Schichtholz oder einem glasfaserverstärkten Kunststoff bestehen.

8. Gradientenspulen-System nach einem der Ansprüche 1 bis 7, dadurch gekennzeichnet, dass die in z-Richtung verlaufenden Trägerelemente (34, 37) mit mehreren, in z-Richtung hintereinanderliegenden, untereinander beabstandeten Ausnehmungen (35, 38) versehen sind.

9. Gradientenspulen-System nach einem der Ansprüche 1 bis 8, dadurch gekennzeichnet, dass die sattelförmigen Gradientenspulen (42) in Teilsättel (43, 44) unterteilt sind.

10. Gradientenspulen-System nach Anspruch 9, dadurch gekennzeichnet, dass die Teilsättel (43, 44) untereinander durch elastische Formstücke (45) beabstandet sind.

11. Gradientenspulen-System nach einem der Ansprüche 1 bis 10, dadurch gekennzeichnet, dass die elastischen Abstandselemente (31) zwischen dem Spulenkorb (2) und dem hohlzylindrischen Trägerkörper (16) in schwingungsarmen Zonen des Spulenkorbes (2) angeordnet sind.

12. Gradientenspulen-System nach einem der Ansprüche 1 bis 11, dadurch gekennzeichnet, dass in dem zwischen dem Spulenkorb (2) und dem hohlzylindrischen Trägerkörper (16) aufgrund der elastischen Abstandselemente (31) ausgebildeten Zwischenraum (32) schallabsorbierendes Material angeordnet ist.

## Claims

1. A gradient coil system, for nuclear magnetic resonance tomography apparatus, enclosing a hollow cylindrical carrier (16) whose cylindrical axis extends in the z-direction of a rectangular x-y-z coordinate system whose coordinate source lies in the centre of a focussing zone, in which direction a magnetic field $B_z$ of a fundamental field magnet comprising a plurality of field coils is also orientated, and where, in order to generate a field gradient $G_z = \dfrac{\delta B_z}{\delta z}$ which is substandially constant in the focussing zone, the gradient coil system includes at least two individual, ring-shaped coils, arranged at least approximately symmetrical to the x-y plane (18) passing through the centre of the focussing zone, and also in each case at least one set of pairs of individual saddle-shaped coils arranged at least approximately symmetrical in relation to this plane of summetry (18) to produce field gradients $G_x = \dfrac{\delta B_z}{\delta x}$ which are substantially constant in the focussing zone in the x-direction and corresponding field gradient $G_y = \dfrac{\delta B_z}{\delta y}$ in the y-direction, characterised in that:

a) the pre-manufactured saddle-shaped $G_x$ and $G_y$ gradient coils (4, 6 and 7; 5, 8 and 9, 42), which are each arranged on one side of the x-y plane of symmetry (18), are rigidly connected to one another to form a self-supporting subsidiary basket (24; 25);

b) by means of a plurality of carrier elements (20 to 22, 34, 37), which extend in the z-direction and consist of non-magnetic, insulating material, the subsidiary baskets (24, 25), formed on both sides of the x-y plane of symmetry (18) provide a common, self-supporting coil basket (2) to which the pre-manufactured, ring-shaped $G_z$ gradient coils (11 to 14) are attached; and

c) the coil basket (2) is applied to the hollow, cylindrical carrier component (16) via insulating, flexible support elements (71).

2. A gradient coil system as claimed in Claim 1, characterised in that the peripheral dimensioning of the saddle-shaped $G_x$ and $G_y$ gradient coils (4 to 9) is such that they mutually overlap.

3. A gradient coil system as claimed in Claim 2, characterised in that the saddle-shaped gradient coils (4, 5; 6 to 9) are arranged of different cylindrical surfaces (29, 30).

4. A gradient coil system as claimed in Claim 2 or 3, characterised in that in their mutual overlap zones the saddle-shaped gradient coils (4 to 9) are mechanically clamped and/or bonded to one another.

5. A gradient coil system as claimed in one of Claims 1 to 4, characterised in that the carrier elements (20 to 22) which extend in the z-direction are each attached to the curved components of the saddle-shaped gradient coils (4 to 9) extending in the peripheral direction.

6. A gradient coil system as claimed in one of Claims 1 to 5, characterised in that the ring-shaped $G_z$ gradient coils (11 to 14) are attached to the radially outer, saddle-shaped gradient coils (4, 5) and carrier elements (21, 22).

7. A gradient coil system as claimed in one of Claims 1 to 6, characterised in that the carrier elements (20 to 22) which extend in the z-direction consist of laminated wood or a glass-fibre reinforced synthetic resin material.

8. A gradient coil system as claimed in one of Claims 1 to 7, characterised in that the carrier elements (34, 37) which extend in the z-direction are provided with a plurality of recesses (35, 38) arranged in series and spaced from one another in the z-direction.

9. A gradient coil system as claimed in one of Claims 1 to 8, characterised in that the saddle-shaped gradient coils (42) are sub-divided into subsidiary saddle-shaped components (43, 44).

10. A gradient coil system as claimed in Claim 9, characterised in that the subsidiary saddle-shaped components (43, 44) are spaced from one another by flexible shaped components (45).

11. A gradient coil system as claimed in one of Claims 1 to 10, characterised in that the flexible spacer elements (31) are arranged between the coil basket (2) and the hollow cylinder carrier component (16) in low-oscillation zones of the coil basket (2).

12. A gradient coil system as claimed in one of Claims 1 to 11, characterised in that sound-absorbent material is arranged in the interspace (32) formed between the coil basket (2) and the hollow cylindrical carrier component (16) by the flexible spacer elements (31).

## Revendications

1. Système de bobines de gradient pour une installation de tomographie à spin nucléaire, qui entoure un corps de support (16) en forme de cylindre creux, dont l'axe s'étend dans la direction z d'un système de coordonnées rectangulaires x-y-z, dont le centre des coordonnées se situe au centre d'une zone de formation d'images, direction selon laquelle se trouve également orienté de champ magnétique $B_z$ d'un aimant fournissant un champ de base et comportant plusieurs bobines de champ, le système de bobines à gradient contenant, pour la production d'un gradient de champ $G_z = \dfrac{\delta B_z}{\delta z}$, qui est constant dans une large mesure dans la zone de formation d'images, au moins deux bobines annulaires individuelles, disposées au moins approximativement de façon symétrique par rapport au plan x-y (18) passant par le centre de la zone de formation d'images, et en outre au moins un ensemble respectif de couples, disposés au moins approximativement de façon symétrique par rapport à cet axe de symétrie (18), de bobines individuelles en forme de selles, qui sont destinées à produire des gradients de champ $G_x = \dfrac{\delta B_z}{\delta x}$, dans une large mesure constant dans la zone de formation d'images, dans la direction x et des gradients de champ correspondants $G_y = \dfrac{\delta B_z}{\delta y}$ dans la direction y, caractérisé par le fait

a) que les bobines de gradient $G_x$ et $G_y$ (4, 6 et 7 ou 5, 8 et 9, 42) en forme de selles, préfabriquées et situées respectivement d'un côté du plan de symétrie x-y (18), sont reliées rigidement entre elles de manière à former une nacelle partielle auto-portante (24 ou 25),

b) que les nacelles partielles (24, 25) situées des deux côtés du plan de symétrie x-y (18) forment, à l'aide de plusieurs éléments de support (20 à 22, 34, 37) qui s'étendent suivant la direction z et sont réalisés en un matériau isolant amagnétique, une nacelle porte-bobines auto-portante commune (2), sur laquelle sont fixées les bobines annulaires préfabriquées de gradient $G_z$ (11 à 14), et

c) que la nacelle porte-bobines (2) est montée par l'intermédiaire d'éléments de support isolants et élastiques (31), sur le corps de support en forme de cylindre creux (16).

2. Système de bobines de gradient suivant la revendication 1, caractérisé par le fait que les bobines de gradient $G_x$ et $G_z$ en forme de selles (4 à 9) possèdent une étendue telle suivant la direction circonférentielle qu'elles se recouvrent mutuellement.

3. Système de bobines de gradient suivant la revendication 2, caractérisé par le fait que les bobines de gradients (4, 5 ou 6 à 9) sont disposées sur différentes surfaces cylindriques (29, 30).

4. Système de bobines de gradient suivant la revendication 2 ou 3, caractérisé par le fait que les bobines de gradient en forme de selles (4 à 9) sont bloquées mécaniquement entre elles et/ou collées les unes aux autres dans leur zone de recouvrement réciproque.

5. Système de bobines de gradient suivant l'une des revendications 1 à 3, caractérisé par le fait que les éléments de support (20 à 22), qui s'étendent suivant la direction z, sont fixées respectivement sur les éléments en forme d'arcs de cercle, qui s'étendent dans la direction circonférentielle, des bobines de gradient en forme de selles (4 à 9).

6. Système de bobines de gradient suivant l'une des revendications 1 à 5, caractérisé par le fait que les bobines annulaires à gradient $G_z$ (11 à 14) sont fixées sur les bobines à gradient en forme de selles (4, 5), situées à l'extérieur du point de vue radial, et aux éléments de support (21, 22).

7. Système de bobines de gradient suivant l'une des revendications 1 à 6, caractérisé par le fait que les éléments de support (20 à 22), qui s'étendent suivant la direction z, sont constitués par du bois stratifié ou par une matière plastique renforcée par des fibres de verre.

8. Système de bobines de gradient suivant l'une des revendications 1 à 7, caractérisé par le fait que les éléments de support (34, 37), qui s'étendent suivant la direction z, comportent plusieurs évidements (35, 38) qui sont disposés les uns derrière les autres suivant la direction z et sont distants entre eux.

9. Système de bobines de gradient suivant l'une des revendications 1 à 8, caractérisé par le fait que les bobines à gradient en forme de selles (42) sont subdivisées en selles partielles (43, 44).

10. Système de bobines de gradient suivant la revendication 9, caractérisé par le fait que les selles partielles (43, 44) sont séparées les unes des autres par des pièces de forme élastique (45).

11. Système de bobines de gradient suivant l'une des revendications 1 à 10, caractérisé par le fait que les éléments d'entretroisement élastiques (31) situés entre la nacelle porte-bobines (2) et le corps de support en forme de cylindre creux (16), sont disposés dans des zones ne présentant plus de vibrations, de la nacelle porte-bobines (2).

12. Système de bobines de gradient suivant l'une des revendications 1 à 11, caractérisé par le fait qu'un matériau insonorisant est disposé dans l'espace intercalaire ménagé entre la nacelle porte-bobines (2) et le corps de support en forme de cylindre creux (16), en raison de la présence des éléments élastiques d'entretoisement (31).

FIG 1

FIG 2

F  F  F  F  F  F

y  z  x

22 28 31 6 8 13 14 25 20 24 4 7 2 5 9 16 21 27 11 12

30 29 32

18

FIG 3

FIG 4

FIG 5

FIG 6

FIG 7